# EUROPEAN PATENT APPLICATION

(11) **EP 3 896 851 A1**
(43) Date of publication of application: **20.10.2021**
(21) Application number: 19896370.4
(22) Date of filing: 13.12.2019
(51) Int. Cl.: H03H 9/58

(54) **PIEZOELECTRIC ACOUSTIC FILTER**

(30) Priority: 14.12.2018 CN 201811534362
(71) Applicant: Tianjin University, Tianjin 300072 (CN); Rofs Microsystem (Tianjin) Co., Ltd, Tianjin 300457 (CN)
(72) Inventor: PANG, Wei, Tianjin 300072 (CN); ZHENG, Yunzhuo, Tianjin 300072 (CN)
(74) Representative: Bandpay & Greuter
(86) International application number: PCT/CN2019/125092
(87) International publication number: WO 2020/119780

(57) **Abstract**

The present disclosure provides a piezoelectric acoustic filter. The high performance and high consistency of piezoelectric acoustic filter devices are realized under the condition of micro-assembly. The piezoelectric acoustic filter includes a carrier plate, and an upper wafer and a lower wafer, which are located on the carrier plate and are sequentially arranged from top to bottom; a plurality of through holes are respectively formed in the upper wafer and the lower wafer, or, a plurality of through holes are only formed in the lower wafer; or, the piezoelectric acoustic filter includes a carrier plate, and a first wafer, a second wafer and a third wafer, which are located on the carrier plate and are arranged from top to bottom, and a plurality of through holes are respectively formed in the second wafer and the third wafer.

## Description

### Technical Field

The embodiments of the present disclosure relate to the field of filter devices for communication, in particular to a piezoelectric acoustic filter, which is made by using the principle of piezoelectric effect and can be assembled by gold wire bonding.

### Background Art

At present, small-size filter devices that can meet the needs of communication terminals are mainly piezoelectric acoustic filters. Resonators that constitute this type of acoustic filters mainly include: FBAR (Film Bulk Acoustic Resonator), SMR (Solidly Mounted Resonator) and SAW (Surface Acoustic Wave). Filters made based on the principle of bulk acoustic wave FBAR and SMR (collectively referred to as BAW, bulk acoustic resonators) have the advantages of lower insertion loss and faster roll-off characteristics compared with filters made based on the principle of surface acoustic wave SAW.

Among the many ways that bare chips are used, micro-assembly is a solution often used by module suppliers. It has the characteristics that: a chip is bonded to a carrier plate through conductive adhesive or non-conductive adhesive, the assembly surface of the chip faces upwards, a pad connected to an internal circuit is disposed on the assembly surface of the chip, and a signal or the ground is conducted from the pad to the carrier plate in a gold wire bonding manner. In terms of reliability and assembly route of the micro-assembly, tin soldering is not adopted in general.

The SAW is a piezoelectric device made on a specific piezoelectric crystal and is not compatible with the usual semiconductor silicon process. Therefore, the SAW is mostly made into a plastic-sealing product by flip-chip CSP (chip-scale packaging). The manufacturing process of the BAW is a universal silicon wafer semiconductor technology that can seal and protect the internal resonator through wafer-level bonding, so the micro-assembly can be achieved in the gold wire bonding manner.

However, there is a technical problem in the bonding micro-assembly of the BAW that cannot be solved easily: all bonding wires can be equivalent to an inductor of about 0.3nH-1nH, and for a radio frequency device, whether it is a signal wire or a ground wire, there must be coupling between inductors, that is, mutual inductance. The mutual inductance will generate a greater impact on the characteristics of the filter, which generally affects the position of an out-of-band transmission zero point, thereby affecting the out-of-band suppression of the filter. Therefore, the manufacturing precision requirements for the gold wire bonding micro-assembly of BAW devices are relatively high, especially when the size of the chip is small and the number of gold wires is large, the lengths, included angles, heights and directions of the bonding wires will affect the final performance of the products, and also affect the consistency of the devices in use.

In summary, how to achieve high performance and high consistency of BAW devices under the condition of micro-assembly is still a problem to be solved urgently.

### Summary of the Invention

In view of this, the present disclosure provides a piezoelectric acoustic filter, which realizes the high performance and high consistency of piezoelectric acoustic filter devices under the condition of micro-assembly.

The first object of the present disclosure is to provide a piezoelectric acoustic filter. The piezoelectric acoustic filter includes a carrier plate, and an upper wafer and a lower wafer, which are located on the carrier plate and are sequentially arranged from top to bottom; a sealing ring is arranged between the upper wafer and the lower wafer; an input signal bonding pad and an output signal bonding pad are arranged on the upper surface of the upper wafer, a plurality of through holes are respectively formed in the upper wafer and the lower wafer, an input signal wire is connected to the input signal bonding pad on the upper surface of the upper wafer via a through hole in the upper wafer, and an output signal wire is connected to the output signal bonding pad on the upper surface of the upper wafer via another through hole in the upper wafer; grounding wires are connected to a metallization plane of the lower surface of the lower wafer via the through holes in the lower wafer; and the metallization plane of the lower surface of the lower wafer is connected to a grounding plane of the carrier plate through conductive adhesive.

An input signal bonding finger and an output signal bonding finger are arranged on the carrier plate, the input signal bonding pad on the upper surface of the upper wafer is connected to the input signal bonding finger on the carrier plate through an input signal bonding wire, and the output signal bonding pad on the upper surface of the upper wafer is connected to the output signal bonding finger on the carrier plate through an output signal bonding wire.

The second object of the present disclosure is to provide a piezoelectric acoustic filter. The piezoelectric acoustic filter includes a carrier plate, and an upper wafer and a lower wafer, which are located on the carrier plate and are sequentially arranged from top to bottom; a sealing ring is arranged between the upper wafer and the lower wafer, and an opening is formed in the sealing ring; an input signal bonding pad and an output signal bonding pad are arranged on the upper surface of the lower wafer, a plurality of through holes are formed in the lower wafer, an input signal wire is connected to the input signal bonding pad on the upper surface of the lower wafer through the opening in the sealing ring, and an output signal wire is connected to the output signal bonding pad on the upper surface of the lower wafer through the opening in the sealing ring; grounding wires are connected to a metallization plane of the lower surface of the lower wafer via the through holes in the lower wafer; and the metallization plane of the lower surface of the lower wafer is connected to a grounding plane of the carrier plate through conductive adhesive.

An input signal bonding finger and an output signal bonding finger are arranged on the carrier plate, the input signal bonding pad on the upper surface of the lower wafer is connected to the input signal bonding finger on the carrier plate through an input signal bonding wire, and the output signal bonding pad on the upper surface of the lower wafer is connected to the output signal bonding finger on the carrier plate through an output signal bonding wire.

The third object of the present disclosure is to provide a piezoelectric acoustic filter. The piezoelectric acoustic filter includes a carrier plate, and a first wafer, a second wafer and a third wafer, which are located on the carrier plate and are arranged from top to bottom, and a sealing ring is arranged between the first wafer and the second wafer; an input signal bonding pad and an output signal bonding pad are arranged on the upper surface of the third wafer, a plurality of through holes are formed in the second wafer, and an input signal wire is connected to the input signal bonding pad on the upper surface of the third wafer via a through hole in the second wafer; an output signal wire is connected to the output signal bonding pad on the upper surface of the third wafer via another through hole in the second wafer; a plurality of through holes are also formed in the third wafer, and grounding wires are connected to a metallization plane of the lower surface of the third wafer via the through holes in the second wafer and the through holes in the third wafer in sequence; and the metallization plane of the lower surface of the third wafer is connected to a grounding plane of the carrier plate through conductive adhesive.

An input signal bonding finger and an output signal bonding finger are arranged on the carrier plate, the input signal bonding pad on the upper surface of the third wafer is connected to the input signal bonding finger on the carrier plate through an input signal bonding wire, and the output signal bonding pad on the upper surface of the third wafer is connected to the output signal bonding finger on the carrier plate through an output signal bonding wire.

In the present disclosure, the signal wire of the chip is connected to the carrier plate by forming the through holes in the wafer. During micro-assembly, the metallization plane on the back surface of the chip is bonded to the grounding plane of the carrier plate through the conductive adhesive, the signal bonding pad on the front face of the chip is connected to the signal bonding finger on the carrier plate through the bonding wire, so that the high performance and high consistency of the piezoelectric acoustic filter in the micro-assembly can be ensured. Due to different bonding positions, the lengths and heights of the bonding wires can be reduced to achieve a smaller inductance value than the original.

### Brief Description of the Drawings

The drawings are used for providing a better understanding of the present disclosure, but do not constitute an improper limitation of the present disclosure, wherein:
Fig. 1 is a side view of an existing piezoelectric acoustic filter;
Fig. 2 is a circuit diagram of the existing piezoelectric acoustic filter;
Fig. 3a is a variation diagram of a curve of the existing piezoelectric acoustic filter with respect to mutual inductance M1;
Fig. 3b is a variation diagram of the curve of the existing piezoelectric acoustic filter with respect to mutual inductance M2;
Fig. 4a is a side view of a piezoelectric acoustic filter in a first embodiment;
Fig. 4b is a top view of the piezoelectric acoustic filter in the first embodiment;
Fig. 5 is a side view of a piezoelectric acoustic filter in a second embodiment;
Fig. 6a is a side view of a piezoelectric acoustic filter in a third embodiment;
Fig. 6b is a top view of the piezoelectric acoustic filter in the third embodiment; and
Fig. 7 is a side view of a piezoelectric acoustic filter in a fourth embodiment.

### Detailed Description of the Embodiments

The present disclosure will be further described below in conjunction with the drawings and embodiments.

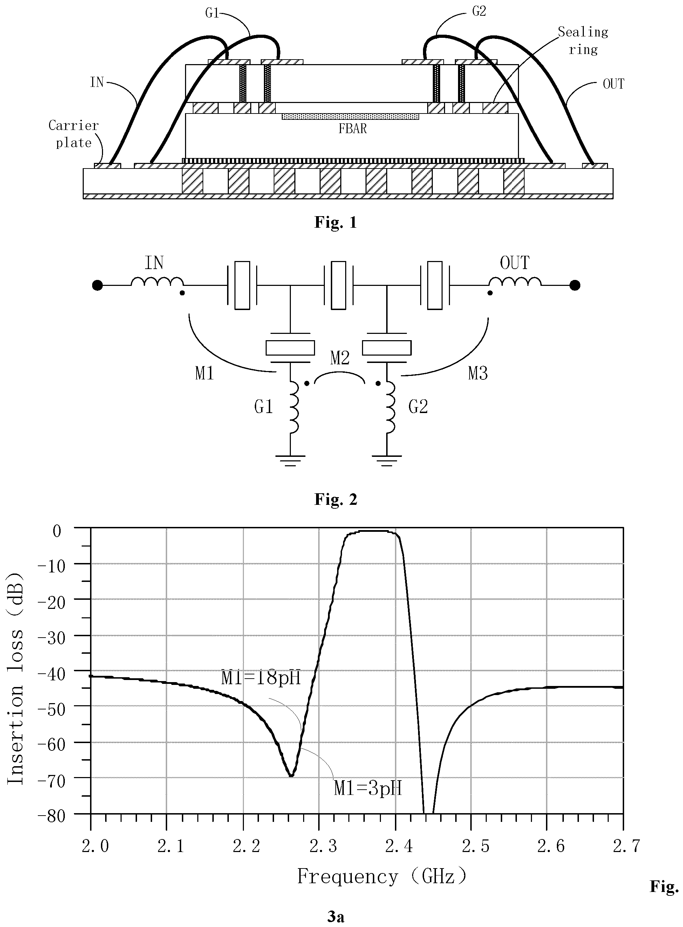

Fig. 1 is a structural diagram of an existing piezoelectric acoustic filter; and Fig. 2 is a circuit diagram of the existing piezoelectric acoustic filter. In Fig. 1, IN represents an input signal bonding wire, OUT represents an output signal bonding wire, G1 represents a grounding bonding wire of a first-level parallel branch, and G2 represents a grounding bonding wire of a second-level parallel branch. Since the bonding wires have certain lengths, the lengths of the four bonding wires IN, OUT, G1 and G2 generally range from 0.5mm to 2mm, and the inductance values introduced by them are generally between 0.4nH and 1.5nH. Due to the small size of a chip and the small distance between the bonding wires, mutual inductance is inevitably introduced. The mutual inductance value is related to the inductance values of the bonding wires themselves and is also related to the distance between the bonding wires, and is generally between 3pH and 20pH. The smaller the distance is, the greater the mutual inductance is, and the greater the distance is, the smaller the mutual inductance is. Since the input and output generally have the farthest distance, and are located on both sides of the chip in the same direction, the mutual inductance between IN and OUT is the minimum and can be ignored. Only the influence of the mutual inductance M1 between IN and G1, the mutual inductance M2 between G1 and G2 and the mutual inductance M3 between G2 and OUT on the performance of the filter are analyzed here. Because the filter can generally be considered as a network reciprocal at both ends from the perspective of the circuit, so M1 and M3 have similar functions in the circuit, and M1 is used as a representative here.

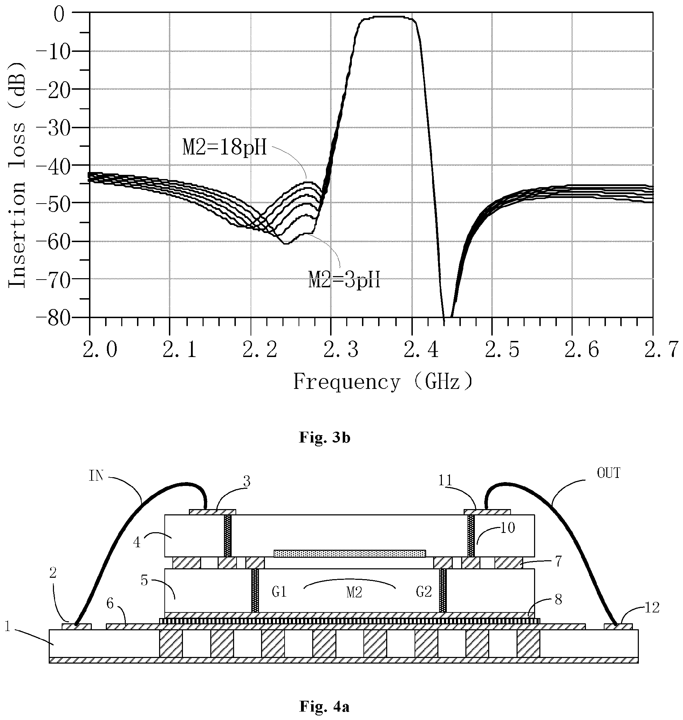

Fig. 3a is a simulation diagram of an amplitude-frequency response curve of the existing piezoelectric acoustic filter varying with the mutual inductance M1 between IN and G1; Fig. 3b is a simulation diagram of the amplitude-frequency response curve of the existing piezoelectric acoustic filter varying with the mutual inductance M2 between G1 and G2; and the variation of the mutual inductance is 3pH-18pH, and the stepping is 3pH. It can be seen from the simulation result in Fig. 3a that the change of M1 has almost no impact on the performance of the filter, and all the curves are almost overlapped together. It can be seen from the simulation result in Fig. 3b that the change of M2 has a greater impact on an out-of-band transmission zero point of the filter, taking 2.27GHz as an example, when M2=3pH, the out-of-band suppression is about -58dB, when M2=18pH, the out-of-band suppression is about -44dB, and even if M2=6pH, the out-of-band suppression here is deteriorated sharply to -53dB, which is deteriorated by 5dB. In the assembly manner of gold wire bonding, since there are greater inconsistencies in the lengths, included angles, heights and directions of the bonding wires, it is taken as an example that the bonding wire is located on the second drop point on a carrier plate, the positional deviation of a bonding point that can be achieved by an existing automatic bonding machine with higher precision is +/-25um. It is very likely that various factors comprehensively cause a change of 5pH or even 20pH to M2, but bonding factors are inevitable.

In order to solve the technical problems existing in the current piezoelectric acoustic filter, the present disclosure divides the bonding wires that need to be interconnected with the carrier plate into two types. One type is a signal bonding wire that is finally connected to a signal wire bonding finger on the carrier plate, and the other type is a ground bonding wire that is connected to the ground of the carrier plate. A signal wire is connected to a bonding pad located on the front face of the chip. By forming through holes in a wafer, ground wires are connected to a metallization plane on the back surface of the chip via the through holes. During micro-assembly, the metallization plane on the back surface of the chip is bonded to a grounding plane of the carrier plate through conductive adhesive, and a signal bonding pad on the front face of the chip is connected to a signal bonding finger on the carrier plate through the bonding wire.

### First embodiment

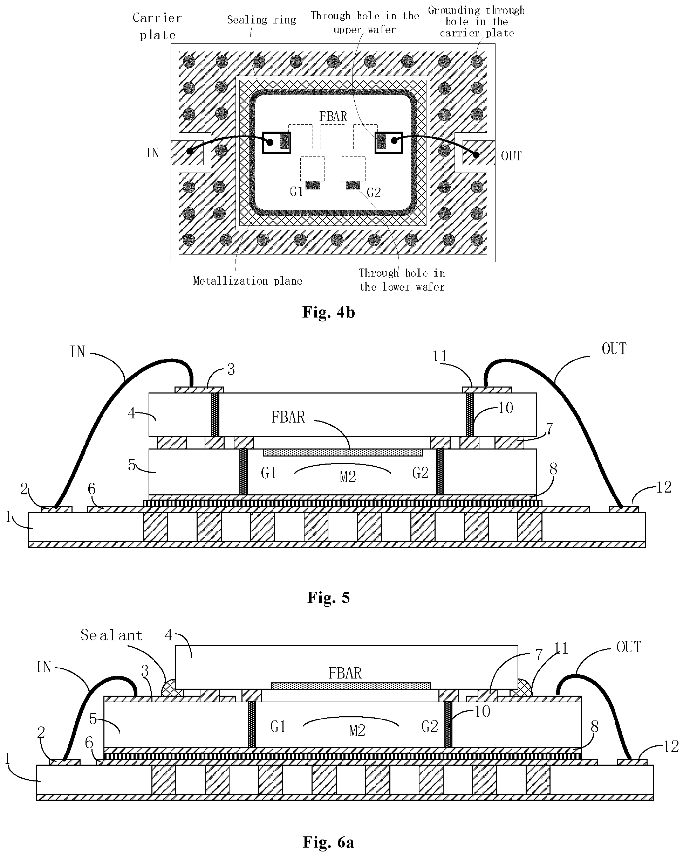

Fig. 4a and Fig. 4b are structural diagrams of a piezoelectric acoustic filter in the present embodiment. In Fig. 4b, two signals IN and OUT are connected to series resonators, are conducted to bonding pads on the upper surface of an upper wafer via through holes in the upper wafer, as shown by a black line rectangle, and then are connected to bonding pads or transmission wires on the carrier plate through bonding wires; and two grounds G1 and G2 are connected to parallel resonators, and are connected to a metallization plane of the lower surface of a lower wafer via through holes in the lower wafer. As shown in Fig. 4a and Fig. 4b, the piezoelectric acoustic filter includes a carrier plate 1, and a chip that is located on the carrier plate 1 and is composed of an upper wafer 4 and a lower wafer 5, an input signal bonding pad 3 and an output signal bonding pad 11 are arranged on the upper surface of the upper wafer 4, and an input signal bonding finger 2 and an output signal bonding finger 12 are arranged on the carrier plate 1; and a sealing ring 7 is arranged between the upper wafer 4 and the lower wafer 5 for sealing a sensitive circuit between the two wafers.

Two through holes 10 are formed in the upper wafer 4, and two through holes 10 are also formed in the lower wafer 5; an input signal wire is connected to the input signal bonding pad 3 on the upper surface of the upper wafer via a through hole in the upper wafer 4; an output signal wire is connected to the output signal bonding pad 11 on the upper surface of the upper wafer via another through hole in the upper wafer 4; grounding wires G1 and G2 are respectively connected to a metallization plane 8 of the lower surface of the lower wafer via the through holes in the lower wafer 5; and the metallization plane 8 of the lower surface of the lower wafer is bonded to a grounding plane 6 of the carrier plate through conductive adhesive. The through holes in the upper wafer 4 and the lower wafer 5 provide an effect of enhanced wafer-level bonding of a bonding area, and realize the electrical interconnection between the two wafers.

The input signal bonding pad 3 on the upper surface of the upper wafer is connected to the input signal bonding finger 2 on the carrier plate through an input signal bonding wire IN, and the output signal bonding pad 11 on the upper surface of the upper wafer is connected to the output signal bonding finger 12 on the carrier plate through an output signal bonding wire OUT, so as to realize the electrical interconnection between the chip and the carrier plate.

According to the piezoelectric acoustic filter proposed in the present embodiment, by using the method of forming the through holes in the silicon wafers, the grounding wires of the chip are connected to the metallization plane on the back surface of the chip via the through holes, while retaining the assembly manner of the input signal bonding wire IN and the output signal bonding wire OUT, which is equivalent to converting the bonding wires sensitive to mutual inductance into the through holes formed by the semiconductor technology and connecting the through holes to the ground. Due to the higher manufacturing process precision of semiconductors, it can be ensured that the mutual inductance M2 can still maintain product consistency even when the assembly precision of the bonding wires is worse, and meanwhile it is also suitable for the micro-assembly process of bonding.

Since the first grounding bonding wire G1 and the second grounding bonding wire G2 are realized by the through holes instead of the original bonding wires, the inductance values thereof will be reduced from the original 0.4nH-1.5nH to 0.05nH-0.3nH, and the reduction of the grounding inductance helps to reduce the mutual inductance therebetween. At the same time, since G1 and G2 are made by the semiconductor technology, and the distance therebetween has um-level precision, the product consistency in micro-assembly can be simultaneously ensured. According to the aforementioned analysis, the mutual inductance between the remaining two IN and OUT signal bonding wires and the grounding inductance has little impact on the final performance of the product.

In the present embodiment, a film bulk acoustic resonator FBAR is arranged on the upper wafer.

### Second embodiment

Fig. 5 is a structural diagram of a piezoelectric acoustic filter in the second embodiment. As shown in Fig. 5, the piezoelectric acoustic filter includes a carrier plate 1, and a chip that is located on the carrier plate 1 and is composed of an upper wafer 4 and a lower wafer 5, an input signal bonding pad 3 and an output signal bonding pad 11 are arranged on the upper surface of the upper wafer 4, and an input signal bonding finger 2 and an output signal bonding finger 12 are arranged on the carrier plate 1; and a sealing ring 7 is arranged between the upper wafer 4 and the lower wafer 5 for sealing a sensitive circuit between the two wafers.

Two through holes 10 are formed in the upper wafer 4, and two through holes 10 are also formed in the lower wafer 5; an input signal wire is connected to the input signal bonding pad 3 on the upper surface of the upper wafer via a through hole in the upper wafer 4; output signal wires are respectively connected to the output signal bonding pad 11 on the upper surface of the upper wafer via another through hole in the upper wafer 4; grounding wires G1 and G2 are respectively connected to a metallization plane 8 of the lower surface of the lower wafer via the through holes in the lower wafer 5; and the metallization plane 8 of the lower surface of the lower wafer is bonded to a grounding plane 6 of the carrier plate through conductive adhesive. The through holes in the upper wafer 4 and the lower wafer 5 provide an effect of enhanced wafer-level bonding of a bonding area, and realize the electrical interconnection between the two wafers.

The input signal bonding pad 3 on the upper surface of the upper wafer is connected to the input signal bonding finger 2 on the carrier plate through an input signal bonding wire IN, and the output signal bonding pad 11 on the upper surface of the upper wafer is connected to the output signal bonding finger 12 on the carrier plate through an output signal bonding wire OUT, so as to realize the electrical interconnection between the chip and the carrier plate.

According to the piezoelectric acoustic filter proposed in the present embodiment, by using the method of forming the through holes in the silicon wafers, the pad above the chip is connected to the metallization plane on the back surface of the chip via the through holes, while retaining the assembly manner of the input signal bonding wire IN and the output signal bonding wire OUT, which is equivalent to converting the bonding wires sensitive to mutual inductance into the through holes formed by the semiconductor technology and connecting the through holes to the ground. Due to the higher manufacturing process precision of semiconductors, it can be ensured that the mutual inductance M2 can still maintain product consistency even when the assembly precision of the bonding wires is worse, and meanwhile it is also suitable for the micro-assembly process of bonding.

Since the first grounding bonding wire G1 and the second grounding bonding wire G2 are realized by the through holes instead of the original bonding wires, the inductance values thereof will be reduced from the original 0.4nH-1.5nH to 0.05nH-0.3nH, and the reduction of the grounding inductance helps to reduce the mutual inductance therebetween. At the same time, since G1 and G2 are made by the semiconductor technology, and the distance therebetween has um-level precision, the product consistency in micro-assembly can be simultaneously ensured. According to the aforementioned analysis, the mutual inductance between the remaining two IN and OUT signal bonding wires and the grounding inductance has little impact on the final performance of the product.

In the present embodiment, a film bulk acoustic resonator FBAR is arranged on the lower wafer

### Third embodiment

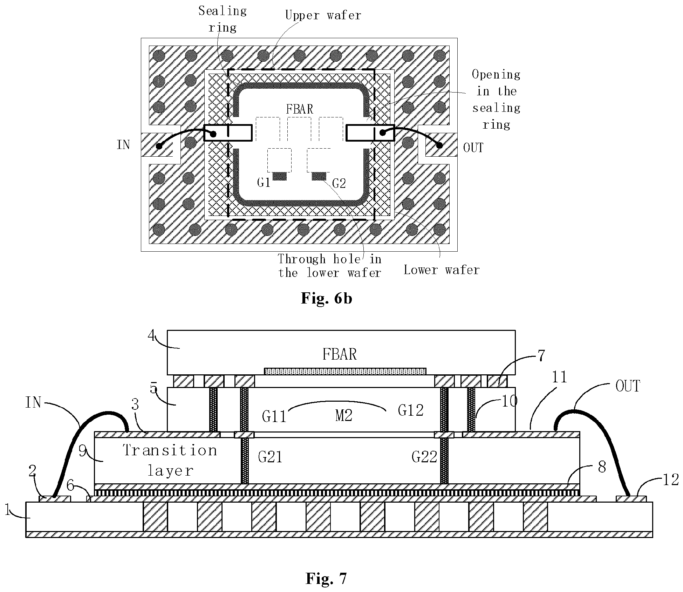

Fig. 6a and Fig. 6b are structural diagrams of a piezoelectric acoustic filter in the third embodiment, wherein the dashed frame in Fig. 6b represents the contour edge of an upper wafer. As shown in Fig. 6a and Fig. 6b, the piezoelectric acoustic filter includes a carrier plate 1, and an upper wafer 4 and a lower wafer 5, which are located on the carrier plate 1 and are arranged from top to bottom, and a sealing ring 7 is arranged between the upper wafer 4 and the lower wafer 5 for sealing a sensitive circuit between the two wafers; and an input signal bonding pad 3 and an output signal bonding pad 11 are arranged on the upper surface of the lower wafer 5, and an input signal bonding finger 2 and an output signal bonding finger 12 are arranged on the carrier plate 1.

Two through holes 10 are formed in the lower wafer 5; an opening is formed in the sealing ring 7, and an input signal wire is connected to the input signal bonding pad 3 on the upper surface of the lower wafer by passing through the opening in the sealing ring; output signal wires are connected to the output signal bonding pad 11 on the upper surface of the lower wafer by respectively passing through the opening in the sealing ring; grounding wires G1 and G2 are respectively connected to a metallization plane 8 of the lower surface of the lower wafer via the through holes in the lower wafer 5; and the metallization plane 8 of the lower surface of the lower wafer is bonded to a grounding plane 6 of the carrier plate through conductive adhesive. The through holes in the lower wafer 5 provide an effect of enhanced wafer-level bonding of a bonding area, and realize the electrical interconnection between the two wafers.

The input signal bonding pad 3 on the upper surface of the lower wafer is connected to the input signal bonding finger 2 on the carrier plate through an input signal bonding wire IN, and the output signal bonding pad 11 on the upper surface of the lower wafer is connected to the output signal bonding finger 12 on the carrier plate through an output signal bonding wire OUT, so as to realize the electrical interconnection between the chip and the carrier plate.

In the present embodiment, a film bulk acoustic resonator FBAR is arranged on the upper wafer.

In the present embodiment, the opening is formed in the sealing ring 7 to ensure that the signal wires pass through to guarantee no short circuit; and non-conductive adhesive for sealing is provided between the opening in the sealing ring and the signal wire, so as to avoid the conduction between the FBAR sensitive circuit and the external environment to ensure the air impermeability of the chip.

Due to different bonding positions, the lengths and heights of the bonding wires can be reduced to achieve a smaller inductance value than the original, such as 0.2nH to 0.4nH.

### Fourth embodiment

Fig. 7 is a structural diagram of a piezoelectric acoustic filter in the fourth embodiment. As shown in Fig. 7, the piezoelectric acoustic filter includes a carrier plate 1, and a first wafer 4, a second wafer 5, and a third wafer 9, which are located on the carrier plate 1 and are arranged from top to bottom, a sealing ring 7 is arranged between the first wafer 4 and the second wafer 5, an input signal bonding pad 3 and an output signal bonding pad 11 are arranged on the upper surface of the third wafer 9, and an input signal bonding finger 2 and an output signal bonding finger 12 are arranged on the carrier plate 1.

A plurality of through holes 10 are formed in the second wafer 5, and input signal wires are connected to the input signal bonding pad 3 on the upper surface of the third wafer via a through hole in the second wafer 5 in sequence; output signal wires are connected to the output signal bonding pad 11 on the upper surface of the third wafer via another through hole in the second wafer 5 in sequence; two through holes 10 are also formed in the third wafer 9, and grounding wires G1 and G2 are respectively connected to a metallization plane 8 of the lower surface of the third wafer via the through holes in the second wafer 5 and the through holes in the third wafer 9 in sequence; and the metallization plane 8 of the lower surface of the third wafer is bonded to a grounding plane 6 of the carrier plate through conductive adhesive. The through holes in the second wafer 5 and the third wafer 9 provide an effect of enhanced wafer-level bonding of a bonding area, and realize the electrical interconnection between the two wafers.

In the present embodiment, the input signal bonding pad 3 on the upper surface of the third wafer is connected to the input signal bonding finger 2 on the same side of the carrier plate through an input signal bonding wire IN, and the output signal bonding pad 11 on the upper surface of the third wafer is connected to the output signal bonding finger 12 on the same side of the carrier plate through an output signal bonding wire OUT.

In the present embodiment, a film bulk acoustic resonator FBAR is arranged on the upper wafer.

According to the piezoelectric acoustic filter proposed in the above embodiment, by forming the through holes in the wafers, the signal wires of the bonding pads are connected to the carrier plate, the metallization plane on the back surface of the chip is glued to the grounding plane of the carrier plate through the conductive adhesive during micro-assembly, the signal bonding pad on the front face of the chip is connected to the signal bonding finger on the carrier plate through the bonding wire, so that the high performance and high consistency of the piezoelectric acoustic filter in the micro-assembly can be ensured. Due to different bonding positions, the lengths and heights of the bonding wires can be reduced to achieve a smaller inductance value than the original.

Although the specific embodiments of the present disclosure are described above in combination with the drawings, the protection scope of the present disclosure is not limited thereto. Those skilled in the art to which the present disclosure belongs should understand that, on the basis of the technical solutions of the present disclosure, various modifications or variations that can be made by those skilled in the art without any creative effect are still within the protection scope of the present disclosure.

## Claims

1. A piezoelectric acoustic filter, comprising a carrier plate, and an upper wafer and a lower wafer, which are located on the carrier plate and are sequentially arranged from top to bottom, wherein a sealing ring is arranged between the upper wafer and the lower wafer; an input signal bonding pad and an output signal bonding pad are arranged on the upper surface of the upper wafer, a plurality of through holes are respectively formed in the upper wafer and the lower wafer, an input signal wire is connected to the input signal bonding pad on the upper surface of the upper wafer via a through hole in the upper wafer, and an output signal wire is connected to the output signal bonding pad on the upper surface of the upper wafer via another through hole in the upper wafer; grounding wires are connected to a metallization plane of the lower surface of the lower wafer via the through holes in the lower wafer; and the metallization plane of the lower surface of the lower wafer is connected to a grounding plane of the carrier plate through conductive adhesive.

2. The piezoelectric acoustic filter according to claim 1, wherein an input signal bonding finger and an output signal bonding finger are arranged on the carrier plate, the input signal bonding pad on the upper surface of the upper wafer is connected to the input signal bonding finger on the carrier plate through an input signal bonding wire, and the output signal bonding pad on the upper surface of the upper wafer is connected to the output signal bonding finger on the carrier plate through an output signal bonding wire.

3. The piezoelectric acoustic filter according to claim 1, wherein a film bulk acoustic resonator is arranged on the upper wafer; or,
a film bulk acoustic resonator is arranged on the lower wafer.

4. A piezoelectric acoustic filter, comprising a carrier plate, and an upper wafer and a lower wafer, which are located on the carrier plate and are sequentially arranged from top to bottom, wherein a sealing ring is arranged between the upper wafer and the lower wafer, and an opening is formed in the sealing ring; an input signal bonding pad and an output signal bonding pad are arranged on the upper surface of the lower wafer, a plurality of through holes are formed in the lower wafer, an input signal wire is connected to the input signal bonding pad on the upper surface of the lower wafer through the opening in the sealing ring, and an output signal wire is connected to the output signal bonding pad on the upper surface of the lower wafer through the opening in the sealing ring; grounding wires are connected to a metallization plane of the lower surface of the lower wafer via the through holes in the lower wafer; and the metallization plane of the lower surface of the lower wafer is connected to a grounding plane of the carrier plate through conductive adhesive.

5. The piezoelectric acoustic filter according to claim 4, wherein an input signal bonding finger and an output signal bonding finger are arranged on the carrier plate, the input signal bonding pad on the upper surface of the lower wafer is connected to the input signal bonding finger on the carrier plate through an input signal bonding wire, and the output signal bonding pad on the upper surface of the lower wafer is connected to the output signal bonding finger on the carrier plate through an output signal bonding wire.

6. The piezoelectric acoustic filter according to claim 4, wherein a film bulk acoustic resonator is arranged on the upper wafer; or,
a film bulk acoustic resonator is arranged on the lower wafer.

7. The piezoelectric acoustic filter according to claim 4, wherein non-conductive adhesive for sealing is provided between the opening in the sealing ring and the signal wire.

8. A piezoelectric acoustic filter, comprising a carrier plate, and a first wafer, a second wafer and a third wafer, which are located on the carrier plate and are arranged from top to bottom, wherein a sealing ring is arranged between the first wafer and the second wafer; an input signal bonding pad and an output signal bonding pad are arranged on the upper surface of the third wafer, a plurality of through holes are formed in the second wafer, and an input signal wire is connected to the input signal bonding pad on the upper surface of the third wafer via a through hole in the second wafer; an output signal wire is connected to the output signal bonding pad on the upper surface of the third wafer via another through hole in the second wafer; a plurality of through holes are also formed in the third wafer, and grounding wires are connected to a metallization plane of the lower surface of the third wafer via the through holes in the second wafer and the through holes in the third wafer in sequence; and the metallization plane of the lower surface of the third wafer is connected to a grounding plane of the carrier plate through conductive adhesive.

9. The piezoelectric acoustic filter according to claim 8, wherein an input signal bonding finger and an output signal bonding finger are arranged on the carrier plate, the input signal bonding pad on the upper surface of the third wafer is connected to the input signal bonding finger on the carrier plate through an input signal bonding wire, and the output signal bonding pad on the upper surface of the third wafer is connected to the output signal bonding finger on the carrier plate through an output signal bonding wire.

10. The piezoelectric acoustic filter according to claim 8, wherein a film bulk acoustic resonator is arranged on the first wafer or the second wafer.
